Europäisches Patentamt

(19) European Patent Office

Office européen des brevets

(11) Numéro de publication: **0 143 700 B1**

(12) **FASCICULE DE BREVET EUROPEEN**

(45) Date de publication de fascicule du brevet:
03.07.91

(21) Numéro de dépôt: 84402348.1

(22) Date de dépôt: 16.11.84

(51) Int. Cl.⁵: **H01L 29/54**, H01L 21/316, H01L 21/285

(54) **Procédé de fabrication de circuit intégré avec connexions de siliciure de tantale et circuit intégré réalisé selon ce procédé.**

(30) Priorité: 22.11.83 FR 8318565

(43) Date de publication de la demande:
05.06.85 Bulletin 85/23

(45) Mention de la délivrance du brevet:
03.07.91 Bulletin 91/27

(84) Etats contractants désignés:
**AT CH DE FR GB IT LI NL SE**

(56) Documents cités:
EP-A- 0 077 200
GB-A- 2 092 373
US-A- 3 967 371
US-A- 3 986 897
US-A- 4 384 301

(73) Titulaire: **SGS-THOMSON MICROELECTRO-
NICS S.A.
7, Avenue Galliéni
F-94250 Gentilly(FR)**

(72) Inventeur: **Baudrant, Annie
THOMSON-CSF SCPI 173, bld Haussmann
F-75379 Paris Cedex 08(FR)**
Inventeur: **Marty, Michel
THOMSON-CSF SCPI 173, bld Haussmann
F-75379 Paris Cedex 08(FR)**

(74) Mandataire: **Guérin, Michel et al
THOMSON-CSF SCPI
F-92045 PARIS LA DEFENSE CEDEX 67(FR)**

## Description

La présente invention concerne les circuits intégrés. Elle sera décrite en détail à propos de la fabrication de circuits à transistors à effet de champ à grille de silicium polycristallin isolée par de l'oxyde de silicium mince, mais elle est applicable à d'autres circuits, par exemple des circuits à transistors bipolaires.

Dans de nombreux circuits, des zones importantes de silicium dopé servent à conduire un courant non négligeable et il est essentiel de réduire autant que possible la résistivité électrique de ces zones. C'est pourquoi on a proposé de former sur ces zones des couches d'alliages métalliques tels que des siliciures de platine, de titane, de tantale qui ont l'avantage d'avoir une très bonne conductivité. Voir par exemple le brevet US-A-4384301 divulguant un circuit intégré conforme au préambule de la revendication 1.

Le platine a l'inconvénient d'être très cher ; le titane "absorbe" beaucoup d' oxygène lors des phases de fabrication qui suivent son dépôt, ce qui nuit à sa conductivité ; de plus les siliciures de ces métaux résistent souvent mal aux agents chimiques : par exemple, le siliciure de titane est soluble dans l'acide fluorhydrique HF qui est utilisé fréquemment pour nettoyer les tranches. Le tantale et son siliciure résistent au contraire très bien à ce type d'agent chimique ; malheureusement ils s'avèrent difficile à graver car, si l'on grave avec un plasma, le siliciure de tantale qu'on voudrait conserver est attaqué plus vite que le tantale qu'on voudrait éliminer ; si au contraire on essaye de graver par voie chimique, il faut des bains à 80° C qui sont difficilement utilisables en production de masse.

La présente invention propose une structure de circuit intégré et un procédé de fabrication correspondant, cette structure utilisant du tantale et bénéficiant donc des avantages de celui-ci sans en présenter les inconvénients : essentiellement, au lieu d'essayer de supprimer le tantale là où on ne désire pas l'allier avec du silicium, on le conserve sous forme d'oxyde de tantale isolant : la structure de circuit selon l'invention est telle qu'on trouve une couche ininterrompue contenant du tantale sur toute l'étendue de la tranche, cette couche étant constituée de siliciure de tantale en contact direct avec du silicium dans certaines zones, et d'oxyde de tantale en contact avec de l'oxyde de silicium sur tout le reste de la tranche.

Plus précisément, le circuit intégré selon l'invention comprend des zones de silicium monocristallin et/ou polycristallin dont certaines au moins sont reliées à des connexions faisant partie d'une couche conductrice d'interconnexion ; ces zones sont entièrement recouvertes de siliciure de tantale et l'espace séparant les zones recouvertes de siliciure de tantale est occupé par une couche d'oxyde de tantale reposant sur un isolant, notamment de l'oxyde de silicium, la couche conductrice d'interconnexion venant en contact ponctuellement avec le siliciure de tantale sur des portions des zones de silicium ainsi recouvertes.

Pour des transistors à effet de champ à grille de silicium polycristallin isolée par de l'oxyde de silicium mince, les régions de source et de drain des transistors sont recouvertes de siliciure de tantale ainsi que la surface supérieure des grilles de silicium polycristallin ; les flancs des grilles sont recouverts d'un remblai d'oxyde de silicium recouvert d'oxyde de tantale comblant entièrement l'espace séparant le siliciure de tantale des sources et drains du siliciure de tantale de la grille.

Le procédé de fabrication utilisé pour obtenir cette structure est le suivant :

- on forme classiquement sur une tranche des zones de silicium dénudées séparées par des zones où un isolant (oxyde de silicium) est présent sur la surface de la tranche ;
- on dépose une couche de tantale uniformément sur la totalité de la surface de la tranche ;
- on soumet la tranche à une température d'environ 750° C en présence d'un gaz neutre, de préférence de l'argon, en atmosphère sèche, pour former ainsi du siliciure de tantale partout où le tantale recouvre directement le silicium dénudé et pour conserver le tantale là où il recouvre l'isolant (oxyde de silicium) ;
- on soumet la tranche à une température d'environ 200° C à 500° C en présence d'un gaz oxydant, de préférence de l'oxygène, en atmosphère sèche, pour oxyder le tantale sans oxyder le siliciure de tantale ;
- on continue le processus de fabrication sans éliminer l'oxyde de tantale subsistant ; notamment, on dépose une couche isolante que l'on grave pour l'ouvrir au dessus de portions de zones de siliciure de tantale, on dépose une couche métallique (alliage d'aluminium et de silicium par exemple) que l'on grave selon le motif d'interconnexion choisi.

La structure selon l'invention a l'avantage d'éliminer tout risque de court-circuit par formation de ponts de siliciure de tantale ou de tantale entre deux zones de silicium qui doivent rester isolées, par exemple entre la grille et la source ou le drain d'un transistor. De plus, le siliciure de tantale peut recouvrir très largement les régions de silicium dont on veut réduire la résistivité, la limite de ces régions étant pratiquement toujours déterminée par une zone d'oxyde de silicium qui délimitera par autoalignement la séparation entre une zone de siliciure de tantale et une zone d'oxyde de tantale.

Dans le procédé de fabrication, aucune étape de masquage ne sera nécessaire pour la définition des zones de siliciure de tantale et on ne se heurtera donc pas à la difficulté de graver le tantale ou le siliciure de tantale.

En particulier, avant le dépôt du tantale, on déposera de l'oxyde de silicium par décomposition en phase gazeuse, oxyde que l'on gravera uniformément selon une attaque anisotrope verticale jusqu'à mettre à nu le silicium monocristallin et polycristallin, en conservant le long des flancs des grilles de silicium polycristallin des remblais d'oxyde isolant qui empêcheront la formation de siliciure sur ces flancs.

On notera qu'un document utilisant une couche de tantale localement oxydée (par masquage) est le brevet US-A-3,967,371.

D'autres caractéristiques et avantages de l'invention apparaîtront à la lecture de la description détaillée qui suit et qui est faite en référence aux dessins annexés dans lesquels:

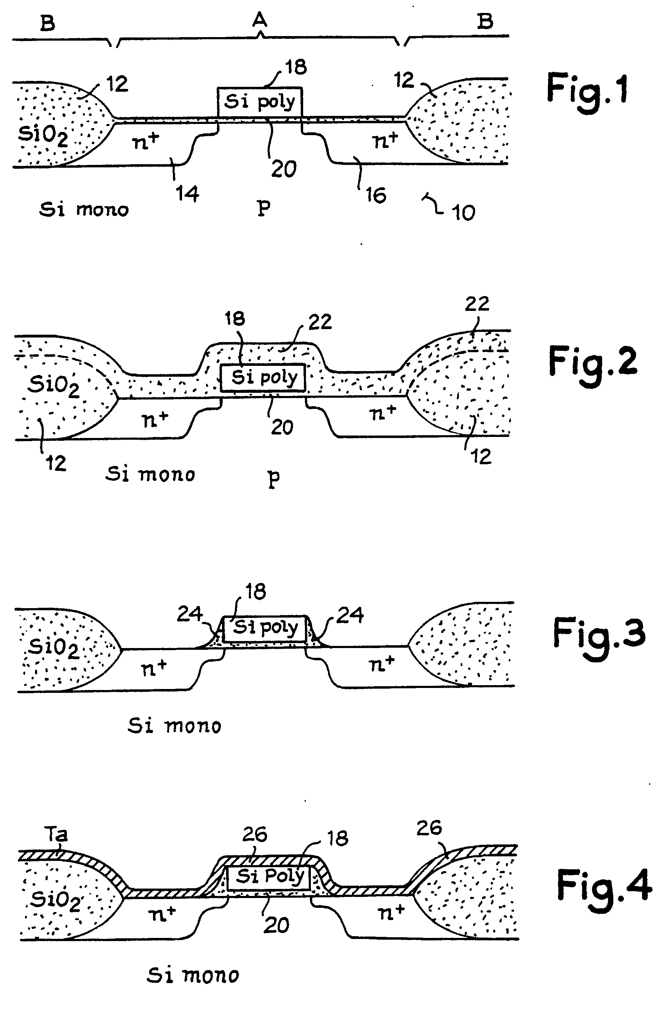

Les figures 1 à 7 représentent les étapes successives de réalisation d'un circuit intégré conforme à l'invention, incorporant des transistors à effet de champ.

On ne redécrira pas en détail les étapes classiques de formation du transistor lui-même: on part d'une tranche de silicium monocristallin 10 dans laquelle on définit des zones actives A isolées les unes des autres par des zones B d'oxyde de silicium épais 12 (fig 1) . On effectue classiquement des implantations et diffusions de source 14 et drain 16 après avoir déposé et gravé une couche de silicium polycristallin définissant notamment les grilles 18 des transistors, ces grilles reposant sur une couche d'oxyde de silicium mince 20. La grille sert de masque d'implantation lors d'une étape d'implantation de source et drain. On prévoit généralement en plus une étape de diffusion profonde de source et de drain et c'est pourquoi on a représenté sur la figure 1 des régions de source et drain en forme d'escalier avec une diffusion peu profonde et autoalignée avec le bord de la grille et une diffusion profonde couvrant la zone active A en dehors de la grille et de ses abords immédiats.

Plusieurs procédés de fabrication sont connus et on considèrera donc qu'il n'y a pas de difficulté pour l'homme de métier à obtenir la structure de la figure 1 ou d'autres structures de technologie MOS ou bipolaire pour lesquelles l'invention peut être intéressante.

Dans l'exemple de structure de départ de la figure 1, on souhaite que les lignes de diffusion de source et drain, qui peuvent réunir plusieurs transistors, ainsi que les grilles de silicium polycristallin, aient une résistivité aussi faible que possible (c'est d'ailleurs une des raisons de l'existence des diffusions profondes de source et de drain).

Pour cela, on propose selon l'invention de réaliser une structure dont la constitution finale est représentée à la figure 7 et qui va être réalisée de la manière suivante.

On dépose d'abord par décomposition chimique en phase gazeuse à basse pression, une couche d'oxyde de silicium 22. Le pouvoir couvrant de ce dépôt est élevé de sorte que la couche s'arrondit autour des bords de la grille et comble largement l'angle droit formé par les flancs de la grille 18 et la surface du silicium monocristallin 10 (fig 2).

On grave alors uniformément l'oxyde de silicium présent, sur une épaisseur légèrement supérieure à l'épaisseur de la couche 22 qui vient d'être déposée, et cette gravure se fait par attaque anisotrope verticale. On arrête la gravure lorsque le silicium monocristallin est mis à nu ainsi que le silicium polycristallin de la grille. On ne poursuit pas la gravure, de sorte qu'il subsiste, du fait de l'anisotropie de la gravure, des remblais 24 d'oxyde de silicium recouvrant les flancs de la grille 18 et comblant le coin formé par le flanc de la grille et la surface du silicium monocristallin de la tranche. La gravure est par exemple une gravure ionique réactive que l'on peut poursuivre par un décapage au plasma de SF6, dans le bâti de pulvérisation de tantale qui va servir à l'étape suivante (bâti à deux chambres), ceci de manière à bien nettoyer le silicium monocristallin et polycristallin sans le remettre ensuite en atmosphère oxydante (fig 3).

On dépose alors, par pulvérisation dans le bâti, une couche uniforme 26 de tantale d'une épaisseur qui peut être d'environ 60nm (600 angströms). Le pouvoir couvrant est également suffisant pour que la couche de tantale déposée ne subisse pas de discontinuité lors du passage des marches constituées par les grilles de silicium polycristallin (fig 4).

Dans les procédés de formation de siliciures habituels, on devrait ici graver le métal déposé pour séparer le métal recouvrant la grille du métal recouvrant la source et du métal recouvrant le drain.

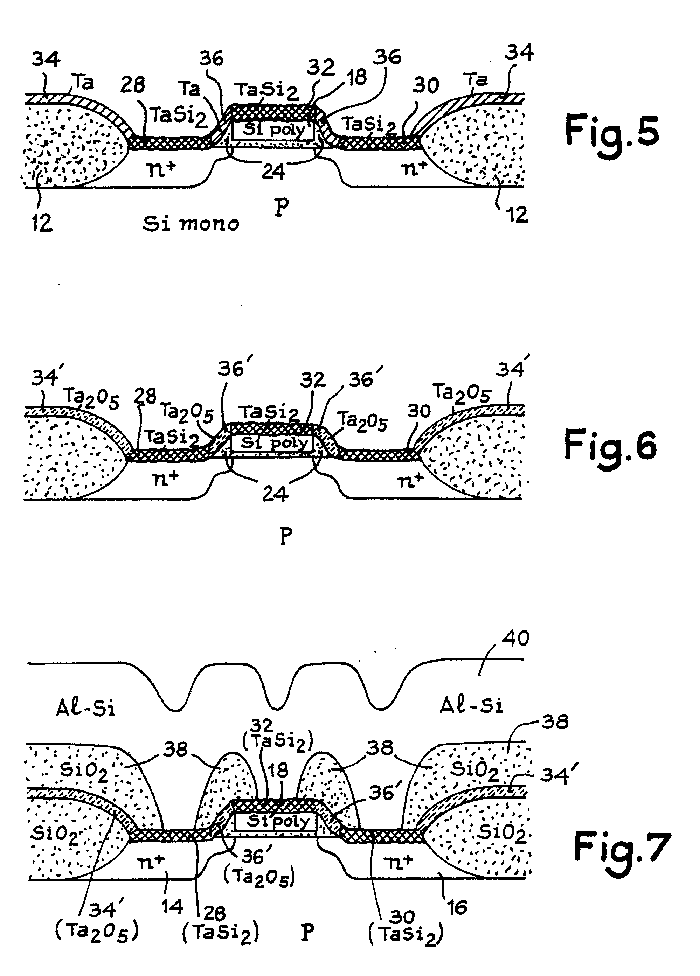

Ici, on soumet la tranche à une température d'environ 750°C pendant une durée d'environ 30 minutes dans une atmosphère désséchée, en présence d'un gaz neutre qui est de préférence de l'argon. Un siliciure de tantale $TaSi_2$ se forme alors là où le tantale est directement en contact avec le silicium monocristallin (zones 28 et 30 au dessus de la source et du drain) ou avec le silicium polycristallin (zone 32 au-dessus de la grille) mais le tantale ne s'allie pas avec le silicium là où il repose sur de l'oxyde de silicium, à savoir d'une part dans les zones 34 recouvrant l'oxyde épais 12 et d'autre part dans les zones 36 au-dessus des remblais 24 d'oxyde de silicium (fig 5).

Il y a encore un court-circuit entre sources, drains et grilles des transistors par l'intermédiaire du tantale des zones 34 et 36, mais déjà les zones de siliciure de tantale sont différenciées des zones de tantale pur, et ceci de manière autoalignée, c'est à dire sans étape de masquage : le siliciure se forme vraiment sur toute la zone de silicium disponible qui a été dénudée à l'étape de la figure 3.

On voudrait éliminer les court-circuits créés par le tantale pur des zones 34 et 36 mais, si on essaie une gravure par plasma, l'alliage TaSi$_2$ est attaqué plus vite que le tantale pur. Une gravure chimique permettrait d'éliminer seulement le tantale mais nécessiterait un bain à 80°C qui est pratiquement irréalisable en production de masse.

Plutôt que d'essayer une telle gravure, on soumet la tranche à une oxydation à basse température (entre 200°C et 500°C), en atmosphère sèche, par exemple en présence d'oxygène sec, de manière à oxyder le tantale sans oxyder le siliciure de tantale. A cette température, cette étape est totalement inerte vis à vis des constituants autres que le tantale.

La durée d'oxydation est de l'ordre de une heure de manière à transformer complètement toute l'épaisseur du tantale des zones 34 et 36 en oxyde de tantale Ta$_2$O$_5$ (zones 34' et 36'). L'oxyde de tantale est un très bon isolant (fig 6).

Ni l'oxyde de tantale, ni le siliciure de tantale ne sont gravés et l'étape suivante de fabrication consiste à déposer à basse température une couche 38 d'oxyde de silicium épais (environ 600nm (6000 Angströms)) que l'on grave classiquement pour créer des ouvertures ponctuelles de prise de contact d'interconnexion métallique sur des portions de zones de siliciure de tantale. On dépose alors une couche d'interconnexion métallique qui peut être un alliage à base d'aluminium, par exemple Al-si ou Al-Si-Cu ou Al-Ta (fig 7).

On grave alors cette couche selon le motif d'interconnexion désirée, on passive la surface du substrat et on ouvre les plages de contact de fils de soudure au boîtier du circuit (étapes non représentées).

Ainsi, dans la structure de circuit intégrée selon l'invention, visible à la figure 7 à son stade presque final, toutes les zones de silicium monocristallin ou polycristallin qui ne sont pas directement recouvertes par de l'oxyde de silicium, sont entièrement recouvertes de siliciure de tantale ; c'est le cas de la majeure partie des zones de source et de drain ; c'est le cas aussi de la totalité de la surface supérieure de la grille; ces zones de silicium recouvertes de siliciure de tantale sont séparées par des portions ininterrompues d'une couche d'oxyde de tantale reposant sur de l'oxyde de silicium ; c'est le cas entre deux transistors, au-dessus de l'oxyde de champ épais qui sépare une zone active d'une autre ; c'est le cas aussi entre la source et la grille ou entre le drain et la grille d'un même transistor. Une couche conductrice d'interconnexion vient en contact ponctuellement avec le siliciure de tantale sur des portions des zones de silicium recouvertes de siliciure de tantale.

On peut envisager que la couche d'interconnexion conductrice soit constituée non pas par un alliage d'aluminium, mais par exemple par du silicium polycristallin qui lui même pourra être allié sous forme de siliciure à un autre métal déposé sur ce silicium polycristallin, constituant ainsi un premier niveau d'interconnexion à partir duquel on pourra éventuellement faire d'autres niveaux d'interconnexion.

Pour terminer cette description, on doit mentionner que l'invention est applicable même à des circuits intégrés formés sur des substrats autres que des substrats de silicium (substrats isolants ou substrats en un autre semiconducteur).

## Revendications

1. Circuit intégré, comprenant des zones de silicium mono cristallin et/ou polycristallin entièrement recouvertes de siliciure de tantale, certaines au moins de ces zones étant reliées à des connexions d'une couche conductrice d'interconnexion (40), qui vient en contact ponctuellement avec le siliciure de tantale sur des portions des zones de silicium ainsi recouvertes, caractérisé en ce que l'espace séparant les zones recouvertes de siliciure de tantale est occupé par une couche (34', 36') d'oxyde de tantale reposant sur un isolant, notamment de l'oxyde de silicium (12,24).

2. Circuit intégré selon la revendication 1, dans lequel sont réalisés des transistors à effet de champ à grille de silicium polycristallin (18) isolée par de l'oxyde de silicium mince (20), caractérisé en ce que les transistors comportent des régions de source (14) et de drain (16) recouvertes de siliciure de tantale (28,30), en ce que la totalité de la surface supérieure des grilles de silicium polycristallin (18) est recouverte de siliciure de tantale (32), et en ce que les flancs des grilles sont recouverts d'un remblai d'oxyde de silicium recouvert d'oxyde de tantale (36') comblant entièrement l'espace séparant le siliciure de tantale (28,30) des régions de source et de drain du siliciure de tantale (32) de la grille.

3. Circuit intégré selon l'une des revendications 1 et 2, caractérisé en ce que la couche conductrice d'interconnexion (40) est une couche d'alliage à base d'aluminium reposant sur une couche d'oxyde de silicium épais (38) ouverte uniquement au-dessus de portions de zones de siliciure de tantale, cet oxyde épais (38) recouvrant une couche d'oxyde de tantale (34', 36') présente sur toute la surface du circuit à l'exception des zones (28, 30, 32) de siliciure de tantale.

4. Circuit intégré selon la revendication 3, caractérisé en ce que l'alliage est un alliage d'aluminium et silicium comprenant éventuellement du cuivre, ou encore un alliage aluminium-tantale.

5. Procédé de fabrication d'un circuit intégré comprenant les opérations suivantes :
   - former classiquement sur une tranche des zones de silicium dénudées séparées par des zones où un isolant (12,24), notamment de l'oxyde de silicium, est présent sur la surface de la tranche ;
   - déposer une couche de tantale (26) uniformément sur la totalité de la surface de la tranche ;
   - soumettre la tranche à une température d'environ 750°C en présence d'un gaz neutre, de préférence de l'argon, en atmosphère sèche, pour former ainsi du siliciure de tantale (28, 30, 32) partout où le tantale recouvre directement le silicium et pour conserver du tantale (34, 36) là où il recouvre l'isolant ;
   - soumettre la tranche à une température d'environ 200°C à 500°C en présence d'un gaz oxydant, de préférence de l'oxygène, en atmosphère sèche, pour oxyder le tantale sans oxyder le siliciure de tantale ;
   - continuer le processus de fabrication sans éliminer l'oxyde de tantale (34', 36') subsistant.

6. Procédé de fabrication selon la revendication 5, caractérisé en ce que, préalablement au dépôt de tantale, on forme des transistors à effet de champ à grille de silicium polycristallin (18) isolée du substrat par une couche d'oxyde de silicium (22) déposée par décomposition chimique en phase gazeuse, et on enlève cette couche uniformément par attaque anisotrope verticale jusqu'à mettre à nu le silicium polycristallin de la grille, et le silicium monocristallin de part et d'autre de grille, l'attaque anisotrope laissant subsister un remblai (24) d'oxyde de silicium le long des flancs de la grille.

7. Procédé de fabrication selon l'une des revendications 5 et 6, caractérisé en ce que, après formation de l'oxyde de tantale, on recouvre la tranche d'oxyde de silicium épais (38) que l'on attaque sélectivement au-dessus de portions de zones de siliciure de tantale, puis l'on dépose une couche métallique (40) que l'on grave selon un motif choisi d'interconnexions.

## Claims

1. An integrated circuit comprising monocrystalline and/or polycrystalline silicon regions fully covered with tantalum silicide, at least certain of which are connected to connections of an interconnecting conductive layer (40), coming punctually into contact with the tantalum silicide on portions of the thus covered silicon zones, characterized in this that the space separating the regions covered with tantalum silicide is occupied by a tantalum oxide layer (34', 36') lying on an insulator, especially silicon oxide (12, 24).

2. An integrated circuit according to claim 1, wherein are realized field effect transistors having a polycrystalline silicon gate (18) insulated by a thin silicon oxide layer (20), characterized in this that the transistors comprise source (14) and drain (16) regions covered with tantalum silicide (28, 30), the whole of the upper surface of the polycrystalline silicon gates (18) are covered with tantalum silicide (32), and the sides of the gates are covered with a silicon oxide deposit covered with tantalum oxide (36') completely filling the space separating the tantalum silicide (28, 30) of the source and drain regions from the tantalum silicide (32) of the gate.

3. An integrated circuit according to claim 1 or 2, characterized in this that the interconnecting conductive layer (40) is a layer of aluminum-based alloy lying on a thick silicon oxide layer (38) open solely above portions of the tantalum silicide, this thick oxide (38) covering a tantalum oxide layer (34', 36') present on the entire surface of the circuit with the exception of the tantalum silicide regions (28, 30, 32).

4. An integrated circuit according to claim 3, characterized in this that the alloy is an aluminum-silicon alloy possibly comprising copper or an aluminum-tantalum alloy.

5. A process for manufacturing an integrated circuit comprising the following operations :
   - forming conventionally on a wafer bare silicon regions separated by regions where an insulator (12, 24), especially silicon oxide, is present on the surface of the wafer;

- depositing a tantalum layer (26) uniformly on the whole surface of the wafer;
- submitting the wafer to a temperature of about 750° C in the presence of a neutral gas, preferably argon, in dry atmosphere, in order to form thereby tantalum silicide (30, 32) throughout where the tantalum directly covers the silicon and in order to preserve tantalum (34, 36) where it covers the insulator;
- submitting the wafer to a temperature of about 200° C to 500° C in the presence of an oxidizing gas, preferably oxygen, in dry atmosphere, in order to oxidize the tantalum without oxidizing the tantalum silicide;
- continuing the manufacturing process without eliminating the remaining tantalum oxide (34', 36').

6. A manufacturing process according to claim 5, characterized in this that, prior to the deposit of the tantalum, field effect transistors are formed with a polycrystalline silicon gate (18) insulated from the substrate by a thin silicon oxide layer (22) deposited by chemical vapor deposition, and this layer is uniformly removed by vertical anisotropic etching until the gate polycrystalline silicon and the monocrystalline silicon on either side of the gate are exposed, the anisotropic etching allowing a silicon oxide deposit (24) to remain along the sides of the gate.

7. A manufacturing process according to one of claims 5 and 6, characterized in this that, after formation of tantalum oxide, the wafer is covered with thick silicon oxide (38) that is selectively etched over portions of tantalum silicide regions, then a metallic layer (40) is deposited and etched according to a selected interconnecting pattern.

**Ansprüche**

1. Integrierte Schaltung mit monokristallinen und/oder polykristallinen Siliziumzonen, die vollständig mit Tantalsilizid bedeckt sind und von denen zumindest einige mit einer leitenden Zwischenverbindungsschicht (40) in Verbindung stehen, welche ihrerseits punktuell in Kontakt mit dem Tantalsilizid oberhalb der derart bedeckten Siliziumzonen steht, dadurch gekennzeichnet, daß der Zwischenraum, der die mit Tantalsilizid bedeckten Zonen voneinander trennt, von einer Tantaloxidschicht (34', 36') belegt ist, die auf einer Isolierung, insbesondere einer aus Siliziumoxid (12, 24) liegt.

2. Integrierte Schaltung nach Anspruch 1, bei der Feldeffekttransistoren mit einem durch eine dünne Siliziumoxidschicht (20) isolierten Gate (18) aus polykristallinem Silizium gebildet werden, dadurch gekennzeichnet, daß die Transistoren mit Tantalsilizid (28, 30) bedeckte Source-Bereiche (14) und Drain-Bereiche (16) aufweisen, daß die gesamte Oberfläche des Gate aus polykristallinem Silizium (18) mit Tantalsilizid (32) bedeckt ist und daß die Gate-Flanken mit einem Wall aus Siliziumoxid bedeckt sind, der seinerseits mit Tantaloxid (36') überzogen ist, wobei dieses Tantaloxid den Zwischenraum zwischen dem Tantalsilizid (28, 30) auf den Source- und Drain-Bereichen einerseits und dem Tantalsilizid (32) auf dem Gate ausfüllt.

3. Integrierte Schaltung nach einem der Ansprüche 1 und 2, dadurch gekennzeichnet, daß die leitende Zwischenverbindungsschicht (40) eine Schicht aus einer Legierung auf der Basis von Aluminium ist, die auf einer dicken Siliziumoxidschicht (38) ruht, welche einzig oberhalb von Teilbereichen der Tantalsilizidzonen offen ist und eine Tantaloxidschicht (34', 36') bedeckt, welche die gesamte Oberfläche der integrierten Schaltung mit Ausnahme der Zonen (28, 30, 32) aus Tantalsilizid bedeckt.

4. Integrierte Schaltung nach Anspruch 3, dadurch gekennzeichnet, daß die Legierung eine Legierung aus Aluminium und Silizium gegebenenfalls mit einem Anteil von Kupfer oder eine Aluminium-Tantal-Legierung ist.

5. Verfahren zur Herstellung einer integrierten Schaltung mit folgenden Schritten:
   - es werden in herkömmlicher Weise auf einer Siliziumscheibe isolierte Siliziumzonen gebildet, wobei die Siliziumzonen von Zonen getrennt sind, wo ein Isoliermaterial (12, 24), insbesondere ein Siliziumoxid auf der Oberfläche der Siliziumscheibe vorhanden ist;
   - es wird gleichmäßig eine Tantalschicht (26) auf der gesamten Oberfläche der Siliziumscheibe abgelagert;
   - die Siliziumscheibe wird in Gegenwart eines neutralen Gases, vorzugsweise Argon, einer Temperatur von ungefähr 750° C in trockener Atmosphäre ausgesetzt, um Tantalsilizid (28, 30, 32) überall dort zu bilden, wo das Tantal das Silizium direkt bedeckt, und um das Tantal (34, 36) dort zu erhalten, wo es das Isoliermaterial bedeckt;

- die Siliziumscheibe wird in Gegenwart eines oxidierenden Gases, vorzugsweise Sauerstoff, einer Temperatur zwischen ungefähr 200°C bis 500°C in trockener Atmosphäre ausgesetzt, um das Tantal, nicht jedoch das Tantalsilizid, zu oxidieren;

- der Herstellungsprozeß wird fortgesetzt, ohne das vorhandene Tantaloxid (34', 36') zu eliminieren.

6. Herstellungsverfahren nach Anspruch 5, dadurch gekennzeichnet, daß vor der Ablagerung von Tantal Feldeffekttransistoren gebildet werden mit einem Gate (18) aus polykristallinem Silizium, das gegenüber dem Substrat durch eine Siliziumoxidschicht (22) isoliert ist, welche durch chemische Abscheidung aus der Dampfphase abgelagert wurde, und daß diese Schicht durch anisotropes vertikales Ätzen gleichmäßig entfernt wird, bis das polykristalline Silizium des Gate und das monokristalline Silizium zu beiden Seiten des Gate freigelegt sind, wobei durch das anisotrope Ätzen ein Wall (24) aus Siliziumoxid entlang der Flanken des Gate verbleibt.

7. Herstellungsverfahren nach einem der Ansprüche 5 und 6, dadurch gekennzeichnet, daß nach der Bildung des Tantaloxids die Scheibe mit einem dicken Siliziumoxid (38) bedeckt wird, das selektiv oberhalb von Teilbereichen der Tantalsilizidzonen geätzt wird, und daß anschließend eine metallische Schicht (40) aufgebracht wird, die mit einem gewählten Verbindungsmuster versehen wird.

B      A      B

18

12    Si poly    12

SiO$_2$

n$^+$      n$^+$

20

14    P    16

Si mono      10

# Fig.1

18   22      22

Si poly

SiO$_2$

n$^+$    20    n$^+$

12   Si mono    P    12

# Fig.2

18

24   Si poly   24

SiO$_2$

n$^+$      n$^+$

Si mono

# Fig.3

Ta    26   18    26

Si Poly

SiO$_2$

n$^+$    20    n$^+$

Si mono

# Fig.4

8

Fig.5

Fig.6

Fig.7